# EUROPEAN PATENT APPLICATION

(11) **EP 4 753 407 A1**
(43) Date of publication of application: **03.06.2026**
(21) Application number: 24215624.8
(22) Date of filing: 27.11.2024
(51) Int. Cl.: H10F 39/15, H10F 39/00

(54) **THREE-DIMENSIONAL INTEGRATED CHARGE-COUPLED DEVICE BASED IMAGER**

(71) Applicant: IMEC vzw, 3001 Leuven (BE)
(72) Inventor: MAHATO, Swaraj Bandhu, 3012 Wilsele (BE); ROSMEULEN, Maarten, 9000 Gent (BE); KIM, Joo Hyoung, 3000 Leuven (BE); GENOE, Jan, 3272 Testelt (BE); DE MUNCK, Koen, 3210 Linden (BE)
(74) Representative: AWA Sweden AB

(57) **Abstract**

A 3D CCD based imager, comprising: a photosensitive layer, comprising a plurality of pixels to perform photoelectric conversion; a CCD gate stack, configured to store and transfer charge; and a readout layer, configured to read out a signal representative of the charge stored in the CCD gate stack. The CCD gate stack comprises: a plurality of gate layers and a plurality of spacer layers, which are alternatingly arranged one on the other along a first direction; a plurality of channels extending in the CCD gate stack along the first direction, for forming a plurality of strings of charge storage capacitors; and a plurality of dielectric layers extending in the CCD gate stack along the first direction, configured to isolate the plurality of channels from the plurality of gate layers.

## Description

### Technical field

The present description relates to a Charge-Coupled Device (CCD) based imager, and in particular to an imager with three-dimensional (3D) integrated CCD between an overlying photosensitive element and underlying readout circuitry.

### Background

A charge-coupled device (CCD) is an integrated circuit containing an array of capacitors. Under the operation of a control circuit, each capacitor can transfer its electric charge to a neighbouring capacitor.

There is a continuous need for high resolution imagers in consumer application such as smartphones. A higher resolution normally means a larger number of pixels on a same or reduced area. Thus, there is a continuous drive towards pixel scaling to reduce pixel pitches, i.e. the distance between the centres of two neighboured pixels, in order to achieve a high resolution. According to the recent research, pixel pitches down to 0.5µm have been demonstrated, see e.g., GD Ryan Lee et al, "A 0.5µm Pixel 3-layer Stacked CMOS Image Sensor with Deep Contact and In-Pixel Cu-Cu Bonding Technology" Samsung, IEDM 2023*.*

However, a continuous pixel scaling has become increasingly difficult to realize, as the pixel pitch approaches the wavelength of light, which limits the pixel sensitivity and full-well capacity, and increases optical and electrical crosstalk.

In automobile, continuous and rapid advancement of vehicle autonomy puts new requirements for high resolution, high dynamic range, global shutter image sensors but all in a small optical format.

Hence, there is a need for a solution to these challenges.

### Summary

An objective of the present invention is to provide an image sensor technology that alleviates at least some of these challenges associated with pixel scaling. To be specific, an objective of the present description is to provide a 3D integrated CCD based image sensor and an imaging method by using the 3D integrated CCD based imager, which can enable not only further pixel scaling with possibility of high dynamic range, but also added pixel functionalities, such as charge domain global shutter, charge domain binning, multiple frame storage per pixel and/or potentially other functionality.

According to a first aspect, there is provided a three-dimensional, 3D, integrated Charge-Coupled Device, CCD, based imager, comprising:
- a photosensitive layer, comprising:
   a plurality of pixels arranged in a two-dimensional, 2D, matrix, each pixel configured to perform photoelectric conversion by generating a charge in response to incident light, and to transfer the charge to a CCD gate stack for storage;
- the CCD gate stack, configured to store and transfer charge; and
- a readout layer, configured to read out a signal representative of the charge stored in the CCD gate stack;
wherein the CCD gate stack comprises:
a plurality of gate layers and a plurality of spacer layers, which are alternatingly arranged one on the other along a first direction;
a plurality of channels extending in the CCD gate stack along the first direction; and
a plurality of dielectric layers extending in the CCD gate stack along the first direction, configured to isolate the plurality of channels from the plurality of gate layers.

Each of the plurality of channels forms, in combination with the plurality of gate layers and at least one of the dielectric layers, a string of charge storage capacitors. Each of the plurality of pixels is configured to connect to one of a plurality of strings of charge storage capacitors, for transferring the generated charge. Each string of the plurality of strings of charge storage capacitors is configured to operate as a charge shift register.

At least a part of the CCD gate stack is sandwiched between the photosensitive layer and the readout layer along the first direction; and the plurality of gate layers comprises at least three gate layers along the first direction, including a first gate layer, a second gate layer, ... , and a last gate layer, wherein the first gate layer is the gate layer closest to the photosensitive layer and the last gate layer is the gate layer closest to the readout layer.

To overcome the constraint of a limited two-dimensional (2D) pixel area, the third dimension has been used by, e.g., making vertical diodes and transfer gates. However, the functionality integration is still limited in 2D.

By building the stack of gate layers and the spacer layers along the first direction (i.e. the third dimension in addition to 2D), the present description discloses a way to realize a vertical functionality integration, which can enable a high resolution CCD based imager, i.e. a maximization of diode charge storage fill factor at a minimal pixel pitch, and many other valuable functionalities, including but not limited to: charge domain global shutter, charge domain binning, multiple frame storage, etc.

The first direction may be perpendicular to a plane of the 2D matrix of the plurality of pixels.

The term "integrated" may refer to the fact that a CCD based imager is a type of integrated circuit, comprising electronic components built onto a single chip. This can make the CCD based imager more compact and efficient, ideal for use in small-sized devices.

The charge stored in a first charge storage capacitor (in close proximity to the photosensitive layer) of one string of charge storage capacitors is transferred to its neighbouring charge storage capacitor of said string by controlling the respective CCD gates. Analogously, the charge can be sequentially transferred through the remaining charge storage capacitors of said string, towards the readout layer.

The dielectric layers and the spacer layers may be of the same material or different materials.

The plurality of dielectric layers may be configured to isolate the plurality of channels from both the plurality of gate layers and the plurality of spacer layers.

At least one of said plurality of pixels may be a photodiode, preferably a Pinned Photodiode, PPD.

A photodiode may be a semiconductor diode sensitive to photon radiation, such as visible light, infrared or ultraviolet radiation, X-rays, etc. The photodiode may comprise a PN semiconductor material which can generate electrons when it absorbs photons.

The photosensitive layer may comprise: a photoelectric conversion layer, configured to generate charge in response to the incident light; and a charge transport layer, configured to collect and transfer the generated charge to the CCD gate stack for storage.

A photoelectric conversion layer can be a thin-film photodiode (TFPD) device comprises or consists of organic materials or comprises quantum dots.

The charge transport layer may serve as an intermediate charge storage or a temporary charge buffer before transferring the charge to the CCD gate stack.

The first gate layer may be a photogate layer configured to control a potential of the charge transport layer.

The photosensitive layer may be made of Si or Ge photodiodes, preferably a Pinned Photodiode, PPD, with deep trench isolation in a silicon substrate.

The photosensitive layer may be integrated with the CCD gate stack by wafer stacking.

The second gate layer may be an input transfer gate, ITG, layer, configured to control charge transfer from the photosensitive layer to the plurality of strings of charge storage capacitors.

The second gate layer being the ITG layer may enable a more compact design, and a further reduced pixel footprint.

The last gate layer may be an output transfer gate, OTG, layer configured to transfer the charge stored in the CCD gate stack to the readout layer.

The second last gate layer, arranged between the last gate layer and the other layers of the plurality of gate layers (except for the last and the second last gate layer), may be a buffer gate layer or an Output Summing Well, OSW, layer.

There may be two or more buffer gate layers or OSW layers.

The last gate layer being the OTG layer may enable a more compact design, and a further reduced pixel footprint.

When the second last gate layer is the OSW layer, the OSW layer may comprise at least a first and a second separated OSW layer portion, e.g., two elongated separated OSW layer portions extending in a second direction.

The second direction may be perpendicular to the first direction. A first group of channels of the plurality of channels may extend through the first separated OSW layer portion along the first direction.

A second group of channels of the plurality of channels may extend through a second separated OSW layer portion along the first direction.

The first group of channels may be a first row of channels of the plurality of channels. The second group of channels may be a second row of channels of the plurality of channels.

By providing more than one separated OSW layer portions, the channels or groups of channels extending through different separated OSW layer portions may be individually controlled, e.g., by feeding different control signals to the separated OSW layer portions.

At least two charge storage capacitors of at least one string of the plurality of strings of charge storage capacitors may be provided with a respective clock signal having a different phase.

At least two neighboured charge storage capacitors of the charge storage capacitors along the first direction of at least one string of the plurality of strings of charge storage capacitors may be provided with a clock signal having the same phase.

Multiple neighboured charge storage capacitors connected to the clock signal having the same phase may function as a large MOS cap and may increase the full well capacity, FWC, of the pixel. This may also provide an increased flexibility of the 3D integrated CCD based imager.

At least two sets of neighboured charge storage capacitors may be connected to two clock signals having different voltages. This may provide a potential slope/gradient inside the channel. During charge accumulation, this may facilitate a fast and full charge transfer from the photosensitive layer to the CCD gate stack.

The readout layer may comprise a plurality of readout circuits, configured to read out the signal representative of the charge stored in the plurality of strings of charge storage capacitors.

At least one string of the plurality of strings of charge storage capacitors may be connected to one of the plurality of readout circuits via a floating diffusion region.

At least a last charge storage capacitor of at least one string of the plurality of strings of charge storage capacitors may be configured to function as a storage Metal Oxide Semiconductor, MOS, capacitor of the floating diffusion region connected to said string of the plurality of strings of charge storage capacitors.

The last charge storage capacitor may be positioned at a distal end of said string of the plurality of strings of charge storage capacitors, wherein the distal end is in electrical charge transfer proximity to the readout layer. The distal end of the said string is in close proximity to the readout layer, and a proximal end of the said string is in close proximity to the photosensitive layer.

At least a last charge storage capacitor of any string of the plurality of strings of charge storage capacitors may be configured to function as a storage Metal Oxide Semiconductor, MOS, capacitor of the floating diffusion region connected to said string of the plurality of strings of charge storage capacitors.

Having or not having at least the last charge storage capacitor function as a storage MOS capacitor of the floating diffusion region may decrease or increase the conversion gain of the pixel accordingly.

Having at least the last charge storage capacitor function as a storage MOS capacitor of the floating diffusion region may increase the charge storage capacity of the sensing node (FD region) to accommodate large number of charges coming from the pixel through the respective CCD channel.

At least two strings of the plurality of strings of charge storage capacitors may be connected to one of the plurality of readout circuits for reading out the signal representative of the charge stored in said at least two strings of the plurality of strings of charge storage capacitors.

At least two strings of the plurality of strings of charge storage capacitors may be connected to the floating diffusion region for connecting to one of the plurality of readout circuits.

By sharing the readout circuits, the number of components needed can be reduced, which can further improve resolution and reduce pixel pitch.

The plurality of channels may be made of a channel material comprising any of: indium gallium zinc oxide, IGZO, indium tin oxide, ITO, indium zinc oxide, IZO, another wide-bandgap semiconductor oxide material, a silicon-based semiconductor material and a III-V semiconductor material.

Wide-bandgap oxide semiconductors may increase a retention time of the charge storage capacitors, which is beneficial.

At least one channel of the plurality of channels may be made of a channel material having a varying dielectric constant along the first direction.

This is advantageous as it may result in a potential gradient along the channel under a same clock voltage. During charge accumulation, this may enable a fast and full charge transfer from the photosensitive layer to the CCD gate stack.

At least one of the plurality of channels and the charge transport layer may be made of a same material.

It is advantageous as it may simplify the manufacturing of the 3D integrated CCD based imager, better charge transfer and reduce the manufacturing cost. Having the channel and the charge transport layer made of the same material may result in a better control on the charge transfer from photosensitive layer to vertical CCD channel and an increased full well capacity of the pixel.

The plurality of gate layers may be made of a gate layer material comprising any of a metal material or doped semiconductor material.

The metal material may comprise any of: platinum, Pt, tantalum, Ta, tantalum nitride, TaN, metal silicide, aluminium, Al, Titanium, Ti, Titanium nitride, TiN, Ruthenium, Ru, Iridium, Ir, Iridium dioxide, IrOz, Ruthenium oxide, RuO₂, Tungsten, W, and Tungsten nitride, WN.

The doped semiconductor material may comprise P+ polysilicon or N+ polysilicon.

Choosing different gate layer materials may provide different properties, such as band-gap width, work functions, thermal properties, weights, and costs, for different imaging requirements and applications.

At least two gate layers of the plurality of gate layers may be made of different gate materials.

The plurality of gate layers may be arranged in a staircase configuration, such that each successive layer of the plurality of gate layers has a length in a second direction being larger than a length in the second direction of its preceding layer of the plurality of gate layers.

The second direction may be perpendicular to the first direction.

Each of the plurality of gate layers may be provided with a contact via for receiving a control signal.

The 3D integrated CCD based imager may comprise an external connector, e.g., a peripheral gate contact (made of W), for connecting to one or more contact vias, such that the gate layers are controllable through the contact vias.

The contact via may facilitate the control of the gate layers.

At least one layer of the plurality of gate layers may comprise multiple sub-steps arranged in a staircase configuration, such that each successive sub-step of said at least one layer has a length in a third direction being larger than a length in the third direction of its preceding sub-step of said at least one layer.

The third direction may be perpendicular to both the first and second direction.

According to a second aspect, there is provided an imaging method performed by using the 3D integrated CCD based imager of the first aspect, comprising:
exposing the photosensitive layer to incident light representative of an image during a frame time;
the plurality of pixels of the photosensitive layer performing photoelectric conversion by generating charge in response to the incident light, and transferring the charge to the CCD gate stack for storage;
the CCD gate stack storing and transferring charge; and
the readout layer reading out a signal representative of the charge stored in the CCD gate stack for reconstructing an image frame representative of the image;
wherein the step of the CCD gate stack storing and transferring charge comprises:
   each string of the plurality of strings of charge storage capacitors
   storing the generated charge transferred from one of the plurality of pixels connected to said string of charge storage capacitors, and
   operating as a charge shift register by transferring the charge along the first direction towards the readout layer for reading out.

The step of exposing the photosensitive layer to incident light representative of an image during a frame time may comprise:
sequentially exposing the photosensitive layer to the incident light with a same or different exposure times a first number of times within the frame time;
wherein the step of the readout layer reading out a signal representative of the charge stored in the CCD gate stack for reconstructing an image frame representative of the image, comprises:
the readout layer sequentially reading out a first number of signal portions of the signal for respectively reconstructing a first number of image subframes, each image subframe at least being partially representative of the image.

The first number of image subframes may have a same subframe time being equal to the frame time divided by the first number.

This is advantageous as it can provide an improved flexibility for different imaging applications.

When the second last gate layer is the OSW layer, the OSW layer may comprise at least a first and a second separated OSW layer portion.

A first group of channels of the plurality of channels may extend through the first separated OSW layer portion along the first direction, and may form a first group of strings of charge storage capacitors.

A second group of channels of the plurality of channels may extend through the second separated OSW layer portion along the first direction, and may form a second group of strings of charge storage capacitors.

The readout layer may comprise a plurality of readout circuits for reading out the signal representative of the charge stored in the plurality of strings of charge storage capacitors.

The first group of strings of charge storage capacitors may be connected to a first group of readout circuits of the plurality of readout circuits via a first group of floating diffusion regions, respectively.

The second group of strings of charge storage capacitors may be connected to a second group of readout circuits of the plurality of readout circuits via a second group of floating diffusion regions, respectively.

The step of the readout layer reading out a signal representative of the charge stored in the CCD gate stack for reconstructing an image frame of the image, may comprise:
resetting the first group of floating diffusion regions,
the first group of readout circuits simultaneously reading out a first group of reset signals of the first group of floating diffusion region, respectively,
controlling the first separated OSW layer portion for transferring the charge stored in the first group of strings of charge storage capacitors to the first group of floating diffusion regions for reading out,
the first group of readout circuits simultaneously reading out a second group of signals representative of the charge stored in the first group of strings of charge storage capacitors, respectively, and
subtracting the first group of reset signals of the first group of floating diffusion region from the second group of signals representative of the charge stored in the first group of strings of charge storage capacitors, respectively, for noise cancellation.

The step of the readout layer reading out a signal representative of the charge stored in the CCD gate stack for reconstructing an image frame of the image, may comprise:
resetting the second group of floating diffusion regions,
the second group of readout circuits simultaneously reading out a first group of reset signals of the second group of floating diffusion regions, respectively,
controlling the second separated OSW layer portion for transferring the charge stored in the second group of strings of charge storage capacitors to the second group of floating diffusion regions for reading out,
the second group of readout circuits simultaneously reading out a second group of signals representative of the charge stored in the second group of strings of charge storage capacitors, respectively, and
subtracting the first group of reset signals of the second group of floating diffusion regions from the second group of signals representative of the charge stored in the second group of strings of charge storage capacitors, respectively, for noise cancellation.

This can enable the correlated double sampling (CDS) operation, which can subtract a reset noise from the readout signal to result in a more accurate signal.

The second aspect may generally present the same or corresponding advantages as the first aspect.

### Brief description of the drawings

The above, as well as additional objects, features, and advantages of the present description, will be better understood through the following illustrative and non-limiting detailed description, with reference to the appended drawings. In the drawings like reference numerals will be used for like elements unless stated otherwise.
Fig. 1 is an exemplary cross-sectional view of a 3D integrated CCD based imager.
Fig. 2 is an exemplary cross-sectional view of a 3D integrated CCD based imager.
Fig. 3A is a perspective view of a channel of a 3D integrated CCD based imager.
Fig. 3B is an exemplary readout layer of a 3D integrated CCD based pixel.
Figs 4A is a perspective view of a plurality of channels of a 3D integrated CCD.
Fig. 4B is an exemplary readout layer of a 3D integrated CCD based imager.
Fig. 5A is an exemplary cross-sectional view of a 3D integrated CCD based imager.
Fig. 5B is an exemplary perspective view of a 3D integrated CCD based imager.
Fig. 5C is an exemplary perspective view of a 3D integrated CCD based imager.
Fig. 6 is an exemplary cross-sectional view of a 3D integrated CCD based imager.
Fig. 7 is an exemplary operation timing diagram of a 3D integrated CCD based imager.
Fig. 8 is an exemplary operation timing diagram of a 3D integrated CCD based imager.
Fig. 9A is an exemplary readout layer of a 3D integrated CCD based imager.
Fig. 9B is an exemplary operation timing diagram of a 3D integrated CCD based imager.

### Detailed description

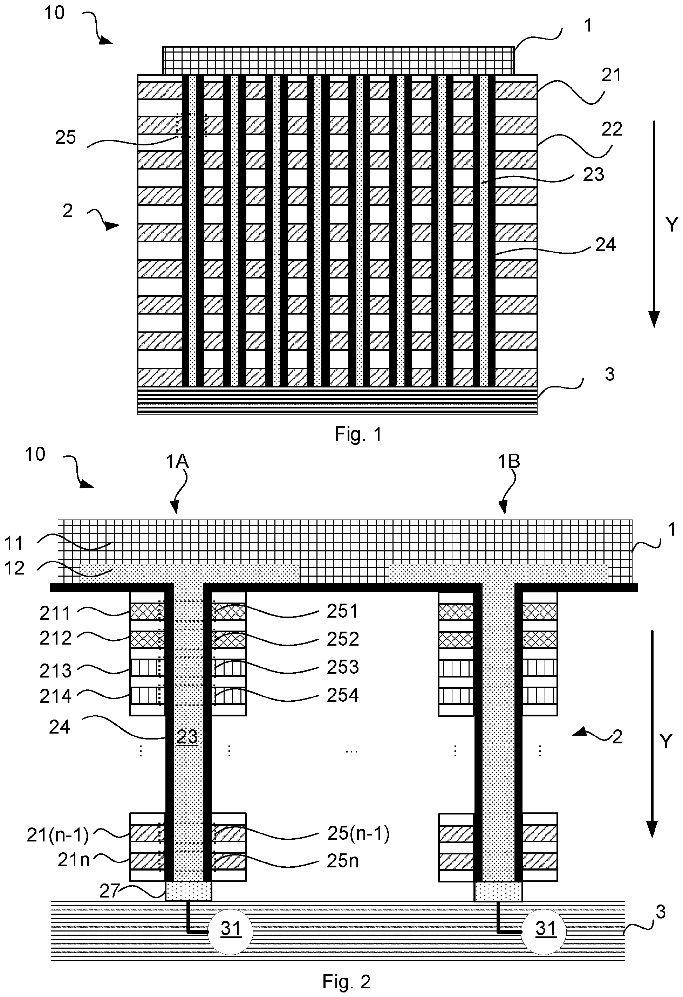

In connection with Fig. 1, a 3D integrated CCD based imager will be discussed in detail.

In Fig. 1, a cross-sectional view of a 3D integrated CCD based imager 10 is illustrated. The 3D integrated CCD based imager 10 comprises three layers, i.e. a photosensitive layer 1, a CCD gate stack 2, and a readout layer 3, arranged along a first direction Y.

The photosensitive layer 1 comprises a plurality of pixels (not shown) arranged in a two-dimensional, 2D, matrix, each configured to perform photoelectric conversion by generating a charge in response to incident light, and to transfer the charge to the CCD gate stack 2 for storage.

The plurality of pixels may be arranged in a plane perpendicular to the first direction Y.

The photosensitive layer 1 may be an overlying photosensitive element.

For example, the pixel may be a regular photodiode implemented in a variety of technologies. The pixel may be a Pinned Photodiode (PPD), implemented in a variety of technologies. The PPD is advantageous as it may provide optimal pixel performance characteristics such as, full reset of the pixel and no reset noise.

The CCD gate stack 2 is configured to store and transfer charge. The charge generated by the photosensitive layer 1 may be stored and transferred by the CCD gate stack 2.

The readout layer 3 is configured to read out the signal representative of the charge stored in the CCD gate stack 2. The readout layer 3 may be an underlying pixel readout element, comprising e.g., a pixel readout circuitry (not shown).

At least a part of the CCD gate stack 2 is sandwiched between the photosensitive layer 1 and the readout layer 3 along the first direction Y.

The CCD gate stack 2 comprises a plurality of gate layers 21 and a plurality of spacer layers 22, which are alternatingly arranged one on the other along the first direction Y.

The CCD gate stack 2 comprises a plurality of channels 23 extending in the CCD gate stack along the first direction Y.

The CCD gate stack 2 comprises a plurality of dielectric layers 24 extending in the CCD gate stack along the first direction Y, configured to isolate the plurality of channels 23 from the plurality of gate layers 21.

The dielectric layers 24 and the spacer layers 22 may be of the same material or different materials.

The plurality of dielectric layers 24 may be configured to isolate the plurality of channels 23 from both the plurality of gate layers 21 and the plurality of spacer layers 22.

Each of the plurality of channels 23 forms, in combination with the plurality of gate layers 21 and at least one of the dielectric layers 24, a string of charge storage capacitors 25.

Each of the pixels of the photosensitive layer 1 is configured to connect to one of the plurality of channels 23 (i.e., in other words, to one of the plurality of strings of charge storage capacitors 25), for transferring the generated charge.

The plurality of gate layers 21 comprises at least three gate layers along the first direction, including a first gate layer 211, a second gate layer 212, ..., and a last gate layer 21n, wherein the first gate layer 211 is the gate layer closest to the photosensitive layer 1 and the last gate layer 21n is the gate layer closest to the readout layer 3.

Each string of the plurality of strings of charge storage capacitors is configured to operate as a charge shift register. That is, the charge stored in a first charge storage capacitor (the charge storage capacitor formed at the first gate layer 211) of one string of charge storage capacitors can be transferred to its neighbouring charge storage capacitor (the charge storage capacitor formed at the second gate layer 212) of said string by controlling the CCD gate layers. Analogously, the charge sequentially can be transferred through the remaining charge storage capacitors of said string, towards the readout layer 3.

The CCD gate stack 2 may provide multiple vertical channels 23 and vertical charge flows between the photosensitive layer 1 and the readout layer 3. Here, the term "vertical" may be understood as that the channels 23 and the charge flows are along the first direction Y, which is perpendicular to the plane of the pixels, e.g., the photosensitive layer 1.

For example, when capturing a first image, each of the plurality of pixels is configured to perform photoelectric conversion by generating a charge in response to incident light. Then, the accumulated charge is transferred and stored in the first charge storage capacitor of each string of the plurality of strings of charge storage capacitors of the CCD gate stack 2. In other words, the first charge storage capacitors of the plurality of strings of charge storage capacitors may together be considered as a 2D image data plane. Subsequently, the accumulated charge can move further to the next storage location along the channel, e.g., the second charge storage capacitor of each of the plurality of strings of charge storage capacitors, to free the first charge storage capacitors for storing the accumulated charge of a next image. The charge may be temporally halted at one or more charge storage capacitors along the string of charge storage capacitors.

In connection with Fig. 2, a 3D integrated CCD comprising two pixels will be discussed in detail.

The photosensitive layer 1 may comprise a layered structure.

The photosensitive layer 1 may comprise a photoelectric conversion layer 11, configured to generate charge in response to the incident light.

The photosensitive layer 1 may comprise a charge transport layer 12, configured to collect and transfer the charge generated by the photoelectric conversion layer 11 to the CCD gate stack 2 for storage.

The first gate layer 211 may be a photogate layer configured to control a potential of the charge transport layer 12. Thus, the first gate layer 211 may control field distribution among all the pixels.

This is advantageous as with a suitable design and voltage configuration, a full reset of the pixel and collection node (i.e. the charge transport layer 12) may be enabled, such that a typical PPD operation (fully depleted diode and no reset noise) can be achieved.

Thus, with the photogate (PG) layer as the first gate layer 211, the 3D integrated CCD based imager can be understood as a backside illuminated photogate pixel structure. The photosensitive materials can be deposited directly on top of the charge transport layer 12. In the case of a metal gate, the incoming light will reflect on the metal gate towards the photodiode to boost the absorption in the photoelectric conversion layer 11.

The generated charge can be stored in the charge transport layer 12 above the first gate layer 211 and besides the first gate layer 211 at the top of the channel 23. Due to the narrow width of the channel 23 and the channels extending along the first direction Y, a high full-well capacity and a small lateral pixel footprint can be achieved. The charge transport layer 12 can also be called an electron transport layer (ETL).

The charge transport layer 12 may be of a semiconductor material, e.g., indium gallium zinc oxide (IGZO).

The photosensitive layer 1 may be formed by a thin film photodiode technology, by using e.g., quantum dots or perovskites.

The photosensitive layer 1 may comprise Si or Ge photodiodes, preferably a Pinned Photodiode (PPD), with deep trench isolation in a silicon substrate.

The photosensitive layer 1 may be integrated with the CCD gate stack 2 by wafer stacking.

In Fig. 2, the photosensitive layer 1 comprises two pixels 1A, 1B to perform photoelectric conversion by generating charge in response to incident light, and to transfer the generated charge to the CCD gate stack 2 for storage.

The plurality of gate layers 21 comprises at least three gate layers along the first direction Y, including a first gate layer 211, a second gate layer 212, ..., and a last gate layer 21n, wherein the first gate layer 211 is in close proximity to the photosensitive layer 1 and the last gate layer 21n is in close proximity to the readout layer 3. n is an integer, and n >= 3.

The channel 23 may be formed by punching a hole through the CCD gate stack 2 along the first direction Y, and filling with a channel material. Such a punching process is also known as a "punch and plug" process, described in e.g., H. Tanaka et al., "Bit Cost Scalable Technology with Punch and Plug Process for Ultra High Density Flash Memory," 2007 IEEE Symposium on VLSI Technology, Kyoto, Japan, 2007, pp. 14-15, doi: 10.1109/VLSIT.2007.4339708*.*

Each pixel 1A, 1B is connected to one channel 23 of the CCD gate stack 2. The per-pixel channel 23 may be considered as a per-pixel memory element. Along the channels 23, a plurality of strings of charge storage capacitors 251, 252, 253, 254, ...., 25n, is formed, in the sense that each channel 23 defines such a string.

The charge transport layer 12 may be of a semiconductor material, e.g., IGZO, which is configured to connect to the channel 23 extending through the stack of the plurality of gate layers 21 and spacer layers 22. In other words, each pixel 1A, 1B may be provided with one channel 23.

The dielectric layer 24 may be provided on the sidewall of the channel 23, which is along the first direction Y.

At least one of the plurality of channels 23 and the charge transport layer 12 may be made of a same material. The charge transport layer 12 and the channel 23 may advantageously be integrated as a single element, as shown in Fig. 2. The channel 23 may be a continuation of the charge transport layer 12.

The readout layer 3 may comprise a plurality of readout circuits 31 configured to read out the signal representative of the charge stored in the plurality of strings of charge storage capacitors 25. Each channel 23 may be connected to one of the plurality of readout circuits 31.

At least one string of the plurality of strings of charge storage capacitors 251, 252, 253, 254, ...., 25n, may be connected to one readout circuit 31 via a floating diffusion region 27.

At least a last charge storage capacitor 25n of at least one string of the plurality of strings of charge storage capacitors may be configured to function as a storage Metal Oxide Semiconductor, MOS, capacitor of the floating diffusion region 27.

The last charge storage capacitor 25n is positioned at a distal end of said string of the plurality of strings of charge storage capacitors, wherein the distal end is in electrical charge transfer proximity to the readout layer 3.

The floating diffusion region 27 may be a sense node connected to a readout circuit 31. The floating diffusion region 27 may be of a diode structure.

The readout layer 3 may further contain additional electronic circuitries (not shown), which are needed for or beneficial to the operation of the 3D integrated CCD based imager. A few examples of the additional electronic circuitries are provided herein.

The readout layer 3 may comprise a clock signal circuitry configured to generate a clock signal for controlling the charge storage capacitors, e.g., for controlling the gate of one or more charge storage capacitors.

The readout layer 3 may comprise an input/output circuitry configured to control data input/output.

The readout layer 3 may comprise a first control circuitry configured to control a temporary charge storage during charge transfer and/or charge buffering.

The readout layer 3 may comprise a second control circuitry configured to control a readout pattern of the 3D integrated CCD based imager.

The readout layer 3 may comprise a third control circuitry configured to control a pixel charge binning.

At least two of the charge storage capacitors 251, 252, 253, 254, ...., 25n of at least one of the plurality of strings of charge storage capacitors may be provided with a respective clock signal having a respectively different phase.

Each of the charge storage capacitors 251, 252, 253, 254, ...., 25n of at least one string of the plurality of strings of charge storage capacitors may be provided with a clock signal having a same phase.

At least two neighboured charge storage capacitors of the charge storage capacitors along the first direction Y of at least one string of the plurality of strings of charge storage capacitors may be provided with a clock signal having the same phase.

The expression "neighboured charge storage capacitors" may refer to two or more charge storage capacitors being sequentially next to each other along a string of charge storage capacitors or along a channel 23 (the first direction Y).

The charge storage capacitors 251, 252 may be provided with a first clock signal have a first phase Φ1, and the charge storage capacitors 253, 254 may be provided with a second clock signal have a second phase Φ2. The first phase Φ1 and the second phase Φ2 may be different.

More than two neighboured charge storage capacitors may be provided with a clock signal having a same phase. For example, the charge storage capacitors 251, 252, 253, 254 may be provided with the first clock signal have the first phase Φ1.

This is advantageous as providing with the clock signal having the same phase may form a large capacitor, e.g., a Metal Oxide Semiconductor (MOS) capacitor. This may increase the full-well capacity (FWC) of the pixel connecting to said string of charge storage capacitors, and also the flexibility of the 3D integrated CCD based imager.

At least two charge storage capacitors or at least two groups of charge storage capacitors of the charge storage capacitors of at least one string of the plurality of strings of charge storage capacitors may be provided with a respective clock signal having a respectively different voltage.

In Fig. 2, the charge storage capacitors 251, 252 may be provided with a first clock signal having a first voltage V1, and the charge storage capacitors 253, 254 may be provided with a second clock signal having a second voltage V2. The first voltage V1 and the second voltage V2 may be different.

This is advantageous as different voltages may provide a potential slope/gradient inside the channel 23. During charge accumulation, the potential slope/gradient may result in a fast and full charge transfer from the photosensitive layer 1 to the CCD gate stack 2.

At least a last charge storage capacitor 25n of any string of the plurality of strings of charge storage capacitors may be configured to function as a storage Metal Oxide Semiconductor, MOS, capacitor of the floating diffusion region 27 connected to said string.

The last charge storage capacitor 25n may be positioned at a distal end of said string of the plurality of strings of charge storage capacitors, wherein the distal end is in electrical charge transfer proximity to the readout layer 3. The distal end of the said string is in close proximity to the readout layer 3, and a proximal end of the said string is in close proximity to the photosensitive layer 1.

One or more of the neighboured charge storage capacitors (along the first direction Y) of the last charge storage capacitor 25n may also be configured to function as a storage MOS capacitor of the floating diffusion region 27 connected to said string.

In Fig. 2, both the last charge storage capacitor 25n and its neighboured charge storage capacitor 25(n-1) may function as a storage MOS capacitor of the floating diffusion region 27 connected to said string.

This is advantageous as by providing these MOS capacitors (MOSC) at the floating diffusion region 27, multiple conversion gains can be achieved for this pixel 1A.

The plurality of gate layers 211, 212, 213, 214, ..., 21(n-1), 21n may be made of a gate layer material comprising any of a metal material or doped semiconductor material.

The metal material may comprise any of: platinum, Pt, tantalum, Ta, tantalum nitride, TaN, metal silicide, aluminium, Al, Titanium, Ti, Titanium nitride, TiN, Ruthenium, Ru, Iridium, Ir, Iridium dioxide, IrOz, Ruthenium oxide, RuO₂, Tungsten, W, and Tungsten nitride, WN.

The doped semiconductor material may comprise P+ polysilicon or N+ polysilicon.

At least two gate layers of the plurality of gate layers 211, 212, 213, 214, ... , 21(n-1), 21n may be made of different gate materials.

In Fig. 2, the gate layers 211, 212 may be made of a first gate material, the gate layers 213, 214 may be made of a second gate material, and the gate layers 21(n-1), 21n may be made of a third gate material.

This is advantageous as it may form a potential gradient along the channel 23.

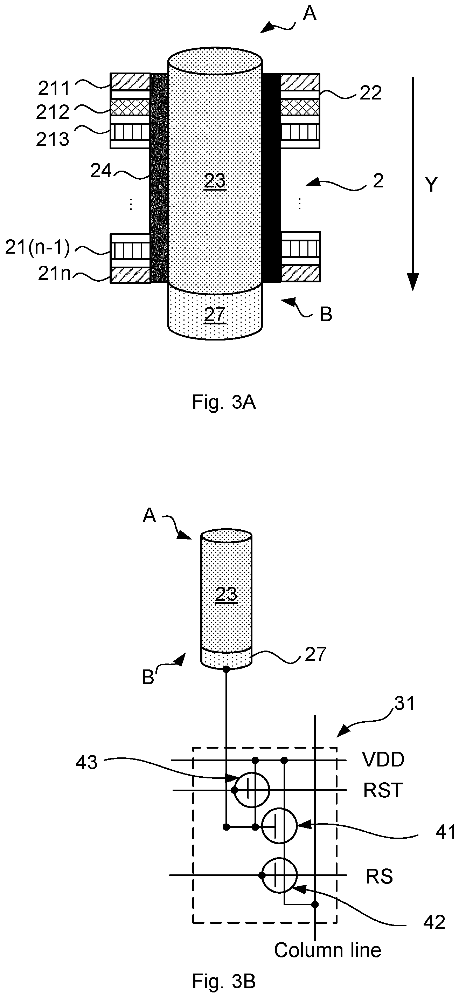

Fig. 3A illustrates one channel 23 of the CCD gate stack 2.

The channel 23 extends in the CCD gate stack 2 along the first direction Y by passing through the plurality of gate layers 21 and the plurality of spacer layers 22, which can form a string of charge storage capacitors.

The first (or proximal) end A of the channel 23 may be configured to connect to the photosensitive layer 1. In other words, the photosensitive layer 1 may provide input to the channel 23 or to the CCD gate stack 2.

The second (or distal) end B of the channel 23 may be configured to connect to the readout layer 3, e.g., the readout circuit 31, via the floating diffusion region 27.

The second gate layer 212 may be an input transfer gate, ITG, layer, configured to control charge transfer along the plurality of channels 23.

The ITG layer 212 may be configured to control charge transfer along the plurality of strings of charge storage capacitors.

The ITG layer 212 may be configured to control transfer of charge from the charge transport layer 12 to the channel 23.

The last gate layer 21n may be an output transfer gate, OTG, layer configured to transfer the charge stored in the CCD gate stack 2 to the readout layer 3.

The second last gate layer 21(n-1), arranged between the last gate layer (21n) and the rest layers of the plurality of gate layers (211, 212, ..., 21(n-2)), may be a buffer gate layer or an Output Summing Well, OSW, layer.

There may be two or more buffer gate layers or OSW, layers. For example, the gate layers 21(n-2) and 21(n-1) may be buffer gate layers or OSW layers.

The plurality of channels 23 may be made of a channel material comprising any of: indium gallium zinc oxide, IGZO, indium tin oxide, ITO, indium zinc oxide, IZO, another wide-bandgap semiconductor oxide material, a silicon-based semiconductor material and a III-V semiconductor material.

At least one channel of the plurality of channels 23 may be made of a channel material having a varying dielectric constant along the first direction Y.

The dielectric constant of the channel material may be spatially varying along the first direction Y. It is advantageous as a continuous potential gradient along the channel may be achieved with a same clock voltage. This may facilitate a fast and full charge transfer from the pixels to the CCD gate stack 2.

Fig. 3B illustrates a conceptual readout circuit 31.

The readout circuit 31 may be connected to the second end B of the channel 23 for reading out the charge stored in the CCD gate stack 2.

Except for the channel 23, the rest of the CCD gate stack 2 is not shown in Fig. 3B.

The readout circuit 31 may be connected to the second end B of the channel 23 via the floating diffusion region 27, as shown in Fig. 3B.

The readout circuit 31 may comprise three transistors as shown in Fig. 3B.

One or more signals may be input to the readout circuit 31 for driving the readout circuit 31, and/or for controlling the readout circuit 31, and/or for performing functionalities of the readout circuit 31.

As shown in Fig. 3B, there are three input signals: a power signal VDD, a reset signal RST, and a row select signal RS, respectively connected to the readout circuit 31 via a power line, a reset line, and a row select line.

The power signal VDD may be used to provide a power supply to the readout circuit 31. For example, the power signal VDD may be used to drive the transistors 41, 42, 43 of the readout circuit 31.

A column line may be provided for reading out the signal representative of the charge stored in the channel (the string of charge storage capacitors) which is connected to the readout circuit 31.

Since the pixels are arranged in a 2D matrix, the row select signal RS and the column line may be used together to determine the signal representative of the charge of any pixels of the plurality of pixels to be read out.

The readout circuit 31 may be formed on a silicon substrate.

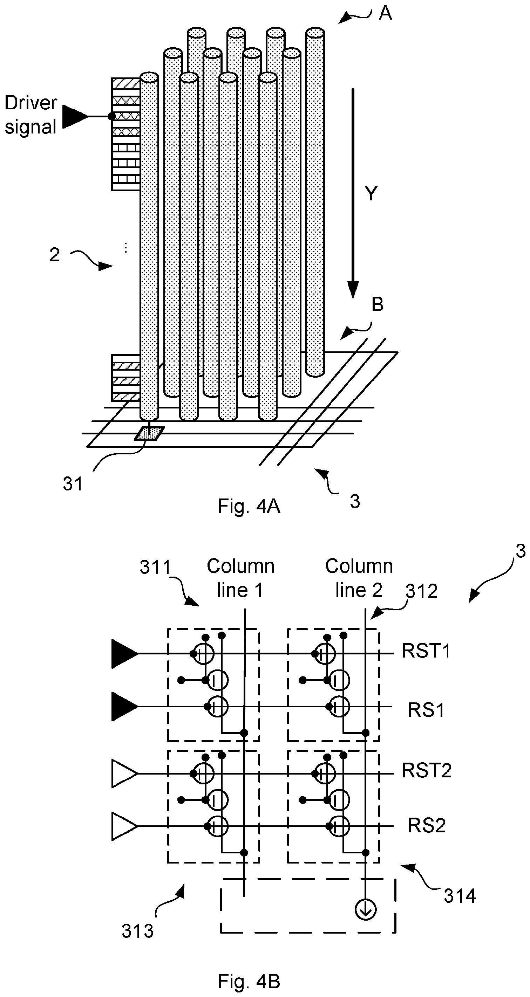

Fig. 4A illustrates multiple channels of the CCD gate stack 2.

The features discussed in Figs 3A and 3B which are the same or similar to those in Fig. 4A, will not be discussed again.

The multiple channels 23 extend in the CCD gate stack 2 along the first direction Y by passing through the plurality of gate layers 21 and the plurality of spacer layers 22, which can form multiple strings of charge storage capacitors. In Fig. 4A, the plurality of gate layers 21 and the plurality of spacer layers 22 are only shown for one channel.

The plurality of dielectric layers 24 and the floating diffusion regions 27 are not shown in Fig. 4A.

The first ends A of the channels 23 may be configured to connect to the photosensitive layer 1. In other words, the photosensitive layer 1 may provide input to the channels 23 or, in other words, to the CCD gate stack 2.

The second end B of the channels 23 may be configured to connect to the readout layer 3, e.g., the readout circuit 31.

The readout circuit 31 may be formed on a plane substantially parallel to the photosensitive layer 1, i.e. substantially perpendicular to the first direction Y.

The term "substantially perpendicular" may refer to that the angle formed between the plane and the first direction Y is 90 degree +/- 5 degree, preferably 90 degree +/- 3 degree, more preferably 90 degree +/- 1 degree.

One driver signal is illustrated in Fig. 4A for one gate layer. However, each of the plurality of gate layers 21 may be provided with a driver signal.

Fig. 4B illustrates a conceptual readout layer 3.

The features discussed in Figs. 3A, 3B, and 4A which are the same or similar to those in Fig. 4B, will not be discussed again.

The readout layer 3 may comprises multiple readout circuits 31, each configured to be connected to the second end B of one channel 23 for reading out the stored charge.

In Fig. 4B, the readout layer 3 comprises an example array of four readout circuits 311, 312, 313, 314, which are arranged in an array (rows and columns). The two rows of the readout circuits 311, 312, 313, 314 are respectively connected to the row select signals RS1, RS2, and respectively connected to the reset signals RST1, RST2. The two columns of the readout circuits 311, 312, 313, 314 are respectively connected to the column line 1, 2.

When the array of readout circuits has more than four readout circuits as shown in Fig. 4B, additional row select signals, additional reset signals, and/or additional column lines may be provided.

The internal connection lines of one readout circuit, e.g., of the readout circuit 311, to the floating diffusion region 27 connected to the readout circuit 311, or between the three transistors 41, 42, 43 of the readout circuit 311, may be associated only to the CCD channel 23, to which the readout circuit 311 is connected.

To better aid understanding, an example of operation will now be described in more detail.

By enabling the row select signal RS1, as shown in Fig. 4B, the readout circuits 311, 312 may be selected. Consequently, the readout circuits 313, 314 are not selected in Fig. 4B.

Thus, the readout circuits 311, 312 among the four readout circuits 311, 312, 313, 314 can be selected by configuring the row select signal RS1 as shown in Fig. 4B. Consequently, the signal representative of the charge stored in the two channels (the strings of charge storage capacitors) which are connected to the readout circuits 311 and 312 can be read out through the column line 1 and 2, respectively.

Analogously, the readout circuits 313, 314 in a different row can be selected by configuring the row select signal RS2 and the signal representative of the charge stored in the two channels which are connected to the readout circuits 313 and 314 can be read out through the column line 1 and 2, respectively.

Thus, a read operation (i.e. an operation of reading out the signal representative of the charge stored in the channels) can be performed in a row-by-row manner by sequentially enabling one of multiple row select signals/lines of the array of the readout circuits. Here, one row of readout circuits may be connected to one row of channels. In other words, the signal representative of the charge stored in the CCD gate stack may be read out in a row-by-row manner. For example, during the read operation of the 3D integrated CCD based imager 10, the signal representative of charge may be read out row-by-row as follows.

Firstly, the row select signal RS1 associated with a first row of the array of the readout circuits may be enabled/activated. This will turn on the transistors 42 of each readout circuits 311, 312 of the first row of the array of readout circuits.

Secondly, the reset signal RST1 associated with the first row may be enabled/activated. This will reset the floating diffusion regions 27 connected to the channels 23, to which the readout circuits 311 and 312 of the first row are connected.

Finally, for each channel 23 connected to the readout circuits 311,312 of the first row, a charge stored in the channel 23 can be pushed out from the string of charge storage capacitors to the floating diffusion region 27. The pushed out charge can be read as a voltage signal by the first (source-follower) transistors 41 of the readout circuits 311 and 312.

The same procedure can then be repeated for a second row, a third row, and so on, until the last row of the array of the readout circuits.

The readout circuits 311, 312, ..., may be formed on a silicon substrate.

The readout circuits 311, 312, ..., may be formed on a plane substantially parallel to the photosensitive layer 1, i.e. substantially perpendicular to the first direction Y.

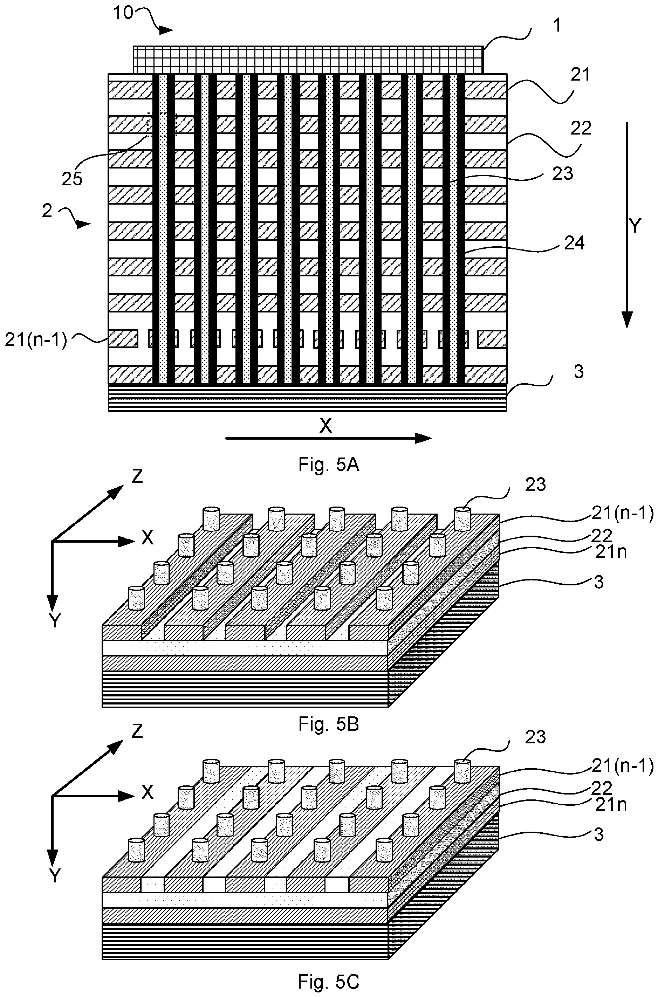

In connection with Figs 5A- 5C, the OSW layer will be discussed in detail.

In the example of Fig. 5A, the second last gate layer 21(n-1) is the OSW layer comprising a plurality of separated OSW layer portions. The OSW layer may comprise a first and a second separated OSW layer portion.

In Fig. 5A, the OSW layer is separated into a plurality of separated OSW layer portions along a direction X. The OSW layer may be separated in different patterns.

A first group of channels of the plurality of channels may extend through the first separated OSW layer portion along the first direction Y, and a second group of channels of the plurality of channels may extend through a second separated OSW layer portion along the first direction Y. The first and the second group of channels may be individually controlled via the first and second separated OSW layer portion, respectively.

This is advantageous as the groups of channels extending through different separated OSW layer portions may be individually (i.e. independently of other groups) controlled, e.g., by controlling one or more signals fed to the separated OSW layer portions.

The signals fed to the separated OSW layer portions may be a High or Low signal.

Fig. 5B is an exemplary perspective view of a 3D integrated CCD based imager comprising a plurality of separated OSW layer portions.

In Fig. 5B, the channels 23 of the CCD gate stack 2 are divided into multiple rows of channels 23.

A first row of channels 23 may extend through the first separated OSW layer portion along the first direction Y, and a second row of channels 23 may extend through the second separated OSW layer portion along the first direction Y.

For example, the first group of channels may be the first row of channels of the plurality of channels 23, and the second group of channels may be the second row of channels of the plurality of channels 23.

Each row of channels 23 may extend through a respective one of the separated OSW layer portions along the first direction Y, such that the rows of channels 23 may be individually controlled via the separated OSW layer portions, respectively.

In Fig. 5B, the plurality of separated OSW layer portions is separated by air.

For example, the OSW layer may be separated (e.g., by patterning) into a plurality of separated elongated OSW layer portions along the direction X, during the fabrication of the CCD gate stack 2.

In Fig. 5C, the plurality of separated OSW layer portions is separated by a material different from the material of the OSW layer. For example, the material for separating the separated OSW layer portions may be the same material of the spacer layers 22.

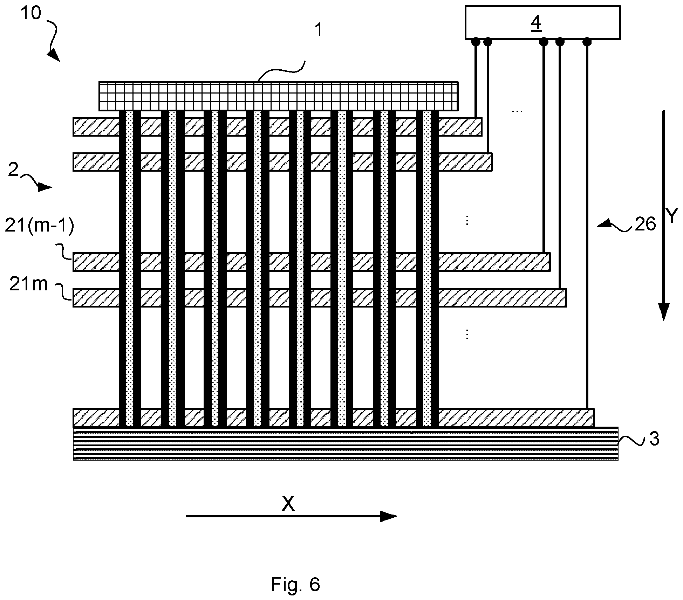

Fig. 6 illustrates a staircase configuration of the plurality of gate layers 21.

The term "staircase configuration" typically refers to a design or arrangement where multiple layers are organized in a step-like pattern, similar to the steps of a staircase.

In Fig. 6, each successive layer 21m has a length in a second direction X being larger than a length in the second direction X of its preceding layer 21(m-1) of the plurality of gate layers 21. m is an integer and 1 < m <= n.

The second direction X is substantially perpendicular to the first direction Y.

It can be seen that each successive gate layer 21m may extend further than its immediately previous gate layer 21(m-1) in the second direction X, which creates a staircase or stepped configuration.

The staircase configuration may provide a space for forming a contact via for each gate layer without interfering with other gate layers. This may increase the connectivity to the periphery circuit of the 3D integrated CCD based imager, which can improve the controllability of the 3D integrated CCD based imager to realize additional functionality.

Each of the plurality of gate layers 21 may be provided with a contact via 26 for receiving a control signal, as shown in Fig. 6.

Through the contact via 26, the gates of the charge storage capacitors can be controlled. However, the skilled person will understand that other control configurations are also conceivable.

For example, the clock signal of the same or different phases may be input through the contact vias 26.

The 3D integrated CCD based imager may comprise an external connector 4, e.g., a peripheral gate contact (made of W), for connecting to one or more contact vias 26 as a control signal.

In Fig. 6, the lengths of the gate layers in the second direction X increase from the photosensitive layer side towards the readout layer side. Thus, it may be convenient to provide the external connector 4 on the photosensitive layer side.

Alternatively, the lengths of the gate layers in the second direction X may decrease from the photosensitive layer side towards the readout layer side. Thus, it may be convenient to provide the external connector 4 on the readout layer side.

One external connector 4 may be provided for each contact via 26. Alternatively, a single external connecter comprising multiple ports may be provided for connecting to multiple contact vias 26, as shown in Fig. 6.

At least one layer of the plurality of gate layers 21 may comprise multiple sub-steps arranged in a staircase configuration, such that each successive sub-step of said at least one layer has a length in a third direction (not shown) being larger than a length in the third direction of its preceding sub-step of said at least one layer. The third direction is substantially perpendicular to both the first direction Y and second direction X.

The present description discloses a 3D integrated CCD based imager which can realize vertical functionality integration in its CCD gate stack. The 3D integrated CCD based imager comprises a photosensitive layer, a readout layer, and a CCD gate stack in between. This is advantageous as it can enable a minimal pixel pitch, a maximization of diode charge storage fill factor, charge domain global shutter, charge domain binning, multiple frame storage per pixel and potentially other functionality. In conclusion, the present description can provide not only a further pixel scaling, but also high resolution added pixel functionality.

The imaging method performed by using the 3D integrated CCD based imager 10 comprises:
exposing the photosensitive layer 1 to incident light representative of an image during a frame time T_{frame};
the plurality of pixels of the photosensitive layer 1 performing photoelectric conversion by generating charge in response to the incident light, and transferring the charge to the CCD gate stack 2 for storage;
the CCD gate stack 2 storing and transferring charge; and
the readout layer 3 reading out a signal representative of the charge stored in the CCD gate stack 2 for reconstructing an image frame representative of the image;
wherein the step of the CCD gate stack 2 storing and transferring charge comprises:
   each string of the plurality of strings of charge storage capacitors 25
   storing the generated charge transferred from one of the plurality of pixels connected to said string of charge storage capacitors 25, and
   operating as a charge shift register by transferring the charge along the first direction Y towards the readout layer 3 for reading out.

The step of exposing the photosensitive layer 1 to incident light representative of an image during a frame time T_{frame}, may comprise:
sequentially exposing the photosensitive layer 1 to the incident light with a same or different exposure times a first number of times within the frame time T_{frame}.

The step of the readout layer 3 reading out a signal representative of the charge stored in the CCD gate stack 2 for reconstructing an image frame representative of the image, may comprise:
the readout layer 3 sequentially reading out a first number of signal portions of the signal for respectively reconstructing a first number of image subframes, each image subframe at least being partially representative of the image.

The first number of image subframes may have a same subframe time T_{subframe}.

The subframe time for each image subframe may be equal to the frame time (T_{frame}) divided by the first number. The exposure time for the different subframes may be different.

By sequentially exposing the photosensitive layer 1 to the incident light a first number of times within the frame time T_{frame}, the 3D integrated CCD based imager is in a "multiple-capture" scheme instead of a "single-capture" scheme having only one exposure during the frame time T_{frame}. Thus, multiple samplings, instead of only one sampling, may be performed during a single frame time.

Since the enlarged storage of the 3D integrated CCD based imager (the strings of charge storage capacitors), and the flexibility to have any number (at least three) of the gate layers 21 in the CCD gate stack 2, the 3D integrated CCD based imager may have the flexibly in choosing the number of samplings within the frame time T_{frame}, and the length of each exposure time.

This may improve the flexibility of using the 3D integrated CCD based imager in different applications.

This is also advantageous as the 3D integrated CCD based imager may be a high dynamic range, global shutter imager.

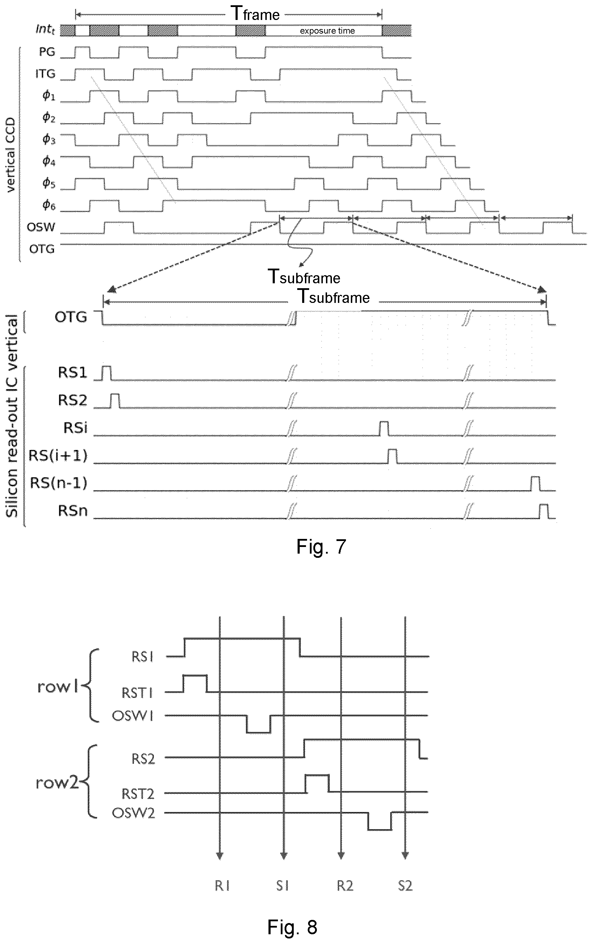

In connection with Fig. 7, an imaging method by using the 3D integrated CCD based imager 10 will be discussed in detail.

In Fig. 7, an operation timing diagram of a 3D integrated CCD based imager having a CCD gate stack 2 comprising ten gate layers 21 is illustrated.

The first gate layer of this example is the photogate layer (PG) configured to control a potential of the charge transport layer 12 of the photosensitive layer 1.

The second gate layer of this example is the input transfer gate (ITG) layer configured to control charge transfer along the plurality of channels 23.

The charge storage capacitors for storing charge may be formed by the channel 23 extending through the third to the eighth gate layer. The charge storage capacitors may be respectively provided with a clock signal having a different phase, e.g., Φ1, ..., Φ6 as shown in Fig. 7.

The ninth layer (i.e. the second last gate layer) of this example is the OSW layer.

The tenth layer (i.e. the last gate layer) of this example is the OTG layer, configured to transfer the charge stored in the CCD gate stack 2 to the readout layer 3.

In Fig. 7, the photosensitive layer 1 (not shown) is sequentially exposed to the incident light representative of an image four (the first number) times within the frame time T_{frame}. In other words, there are four exposures during the frame time T_{frame} in Fig. 7. Between each two consecutive exposures, the photosensitive layer 1 is not exposed to any incident light.

That is, the 3D integrated CCD based imager performs a first number of times (e.g., four times) samplings within the frame time T_{frame}. Each sampling would generate a respective image subframe.

The first number of image subframes may have a same subframe time T_{subframe} being equal to the frame time T_{frame} divided by the first number. In this example, the four subframe times are the same, which is equal to the frame time T_{frame} divided by four, although the exposure times in this example are different.

The multiple subsequential exposures within the frame time T_{frame} may have incremental exposure times. For example, a first exposure time may be 2⁰*T, a second exposure time may be 2¹*T, 2²*T, ..., and a kth exposure time may be 2^{k}*T. T represents a time period.

Multiple subframes (e.g., four subframes as shown in Fig. 7) can be captured within a single frame time T_{frame}, by controlling the PG gate layer and the ITG layer with respect to the multiple exposure times within the frame time T_{frame}.

This is advantageous as by varying the exposure times, e.g., from a short exposure time to a long exposure time, the 3D integrated CCD based imager 10 can achieve a large dynamic range, as a ratio of the long exposure time and the short exposure time.

This is also advantageous as the 3D integrated CCD based imager 10 can facilitate the global shutter operation, where charge of all pixels can be stored intermediately before transferring to the floating diffusion region(s) 27 for reading out.

Optionally, the floating diffusion region(s) 27 may be reset before the charge is transferred to the floating diffusion region(s) 27 for outputting.

When the second last gate layer 21(n-1) is the OSW layer, the OSW layer comprises at least a first and a second separated OSW layer portion, wherein a first group of channels of the plurality of channels 23 extend through the first separated OSW layer portion along the first direction Y, and form a first group of strings of charge storage capacitors 25, and a second group of channels of the plurality of channels 23 extend through the second separated OSW layer portion along the first direction Y, and form a second group of strings of charge storage capacitors 25.

The readout layer 3 may comprise a plurality of readout circuits 31 for reading out the signal representative of the charge stored in the plurality of strings of charge storage capacitors.

The first group of strings of charge storage capacitors 25 may be connected to a first group of readout circuits of the plurality of readout circuits 31 via a first group of floating diffusion regions 27, respectively, and the second group of strings of charge storage capacitors 25 may be connected to a second group of readout circuits of the plurality of readout circuits 31 via a second group of floating diffusion regions 27, respectively;

The step of the readout layer 3 reading out a signal representative of the charge stored in the CCD gate stack 2 for reconstructing an image frame of the image may comprise:
resetting the first group of floating diffusion regions 27,
the first group of readout circuits simultaneously reading out a first group of reset signals of the first group of floating diffusion region 27, respectively,
controlling the first separated OSW layer portion for transferring the charge stored in the first group of strings of charge storage capacitors 25 to the first group of floating diffusion regions 27 for reading out,
the first group of readout circuits simultaneously reading out a second group of signals representative of the charge stored in the first group of strings of charge storage capacitors 25, respectively, and
subtracting the first group of reset signals of the first group of floating diffusion region 27 from the second group of signals representative of the charge stored in the first group of strings of charge storage capacitors 25, respectively, for noise cancellation.

The step of the readout layer 3 reading out a signal representative of the charge stored in the CCD gate stack 2 for reconstructing an image frame of the image may comprise:
resetting the second group of floating diffusion regions 27,
the second group of readout circuits simultaneously reading out a first group of reset signals of the second group of floating diffusion regions 27, respectively,
controlling the second separated OSW layer portion for transferring the charge stored in the second group of strings of charge storage capacitors 25 to the second group of floating diffusion regions 27 for reading out,
the second group of readout circuits simultaneously reading out a second group of signals representative of the charge stored in the second group of strings of charge storage capacitors 25, respectively, and
subtracting the first group of reset signals of the second group of floating diffusion regions 27 from the second group of signals representative of the charge stored in the second group of strings of charge storage capacitors 25, respectively, for noise cancellation.

In connection with Fig. 8, a correlated double sampling (CDS) operation timing diagram of the 3D integrated CCD based imager as shown in Figs 5A- 5C will be discussed in detail.

In Figs 5A- 5C, the second last gate layer 21(n-1) of the 3D integrated CCD based imager is the OSW layer comprising a plurality of separated OSW layer portions.

Each separated OSW layer portion may have a row of channels 23 extending through, such that each row of channels 23 (a group of strings of charge storage capacitors) may be individually controlled via the separated OSW layer portion.

A signal may be connected to each separated OSW layer portion for controlling a respective row of channels 23 (a group of strings of charge storage capacitors) extending through said separated OSW layer portion.

For example, six control signals may be used in this example for illustrating the CDS operation: the row select signals RS1 and RS2, the reset signals RST1 and RST2, the separated OSW layer portion control signals OSW1 and OSW2.

The row select signals RS1 and RS2 may respectively enable row 1 and row 2 of the array of the readout circuits. A row of the readout circuits may be configured to readout charge of a row of the strings of charge storage capacitors (channels 23).

For example, when the row select signal RSn is "High", row n of readout circuits is selected; when the row select signal RSn is "Low", row n is not selected.

The reset signals RST1 and RST2 may be used to reset the floating diffusion region(s) connected to row 1 and row 2 of the readout circuits, respectively.

For example, when the reset signal RSTn is a "High" pulse, the floating diffusion region(s) connected to row n of the readout circuits will be reset; when the reset signal RSTn is "Low", the floating diffusion region(s) connected to row n of the readout circuits is not reset.

The OSW layer control signals OSW1 and OSW2 may be used to respectively transfer charge of the strings of charge storage capacitors connected to the separated OSW layer portions receiving the signal OSW1 and OSW2 to the floating diffusion region(s) for outputting.

For example, when OSWn is a "Low" pulse, the charge of the string of charge storage capacitors connected to the separated OSW layer portion receiving the signal OSWn will be transferred to the floating diffusion region(s) for outputting; when OSWn is "High", no charge is transferred.

In connection with Fig. 8, the CDS operation will be discussed in detail.
1) The row select signal RS1 is set to be "High" to enable row 1 of the readout circuits.

The reset signal RST1 is a "High" pulse to reset the floating diffusion region(s) connected to row 1 of the readout circuits.

The row select signal RS2 and the row reset signal RST2 are inactive, i.e. "Low".

OSW1 and OSW2 are inactive, i.e. "High".

2) A first signal R1 of row 1 is read out, after the floating diffusion region(s) has been reset.

The first signal R1 may comprise a group of signals read out by multiple readout circuits of row 1 of the readout circuits. In other words, multiple readouts may have been done simultaneously by multiple readout circuits of row 1. For example, if there are four readout circuits of row 1, the first signal R1 may comprise readouts from all four readout circuits.

The first signal R1 may represent a combination of a reset voltage (R₀₁) and a noise value. That is, R1=R₀₁ + noise.

All control signals remain unchanged.

3) OSW1 is set to be a "Low" pulse to sum charge of each string of charge storage capacitors connected to the separated OSW layer portion receiving the signal OSW1 for outputting.

All other control signals remain unchanged.

4) A second signal S1 of row 1 is read out.

The second signal S1 may comprise a group of signals read out by multiple readout circuits of row 1 of the readout circuits. In other words, multiple readouts may have been done simultaneously by multiple readout circuits of row 1. For example, if there are four readout circuits of row 1 each connected to a string of charge storage capacitors, the second signal S1 may comprise readouts from all four strings of charge storage capacitors.

The second signal S1 of row 1 may be representative of the charge stored in the strings of charge storage capacitors connected to the separated OSW layer portion receiving the signal OSW1.

The second signal S1 may be the signal representative of the charge stored in the CCD gate stack 2 to be read out above the reset level, i.e. the reset voltage.

The first signal R1 and the second signal S1 of row 1 are available for further processing. If the exact signal corresponding to the charge stored in the CCD gate stack 2 is S₀₁, then S1=S₀₁ + R1=S + R₀₁ + noise.

5) The row select signal RS1 is set to be "Low" to disable row 1; and the row select signal RS2 is set to be "high" to enable row 2 of the readout circuits.

The reset signal RST2 is a "High" pulse to reset the floating diffusion region(s) connected to row 2 of the readout circuits.

All other control signals remain unchanged.

6) A first signal R2 of row 2 is read out, after the floating diffusion region(s) has been reset.

The first signal R2 may comprise a group of signals read out by multiple readout circuits of row 2 of the readout circuits. In other words, multiple readouts may have been done simultaneously by multiple readout circuits of row 2. For example, if there are four readout circuits of row 2, the first signal R2 may comprise readouts from all four readout circuits.

The first signal R2 may represent a combination of a reset voltage (R₀₂) and a noise value. That is, R2=R₀₂ + noise.

All control signals remain unchanged.

7) OSW2 is set to be a "Low" pulse to sum charge of the string of charge storage capacitors connected to the separated OSW layer portion receiving the signal OSW2 for outputting.

All other signals remain unchanged.

8) A second signal S2 of row 2 is read out.

The second signal S2 may comprise a group of signals read out by multiple readout circuits of row 2 of the readout circuits. In other words, multiple readouts may have been done simultaneously by multiple readout circuits of row 2. For example, if there are four readout circuits of row 2 each connected to a string of charge storage capacitors, the second signal S2 may comprise readouts from all four strings of charge storage capacitors.

The second signal S2 of row 2 may be representative of the charge stored in the string of charge storage capacitors connected to the separated OSW layer portion receiving the signal OSW2.

The second signal S2 may be the signal representative of the charge stored in the CCD gate stack 2 to be read out above the reset level, i.e. the reset voltage.

The first signal R2 and the second signal S2 of row 2 are available for further processing. If the exact signal corresponding to the charge stored in the CCD gate stack 2 is S₀₂, then S2=S₀₂ + R2=S₀₂ + R₀₂ + noise.

In Fig. 8, only the operation timing diagram for row 1 and row 2 are illustrated. However, there may be additional rows operating in a way similar to the above.

The CDS operation may be performed in a row-by-row manner by sequentially enabling each row of multiple rows of the readout circuits by selecting said row, by resetting the floating diffusion region(s) of said row to read out the first signal Rn, by enabling the separated OSW layer portion for transferring the charge to the floating diffusion region(s) of said row to read out the second signal Sn.

For any row, subtracting the first signal Rn from the second signal Sn respectively may extract the signal (S₀ₙ) representative of the charge stored in in the CCD gate stack 2 without the reset value (R₀ₙ) and noise, Sn - Rn = (S₀ₙ + R₀ₙ + noise) - (R₀ₙ + noise) = S₀ₙ.

This is advantageous as it may effectively reduce reset noise or charge from real charge in response to incident light.

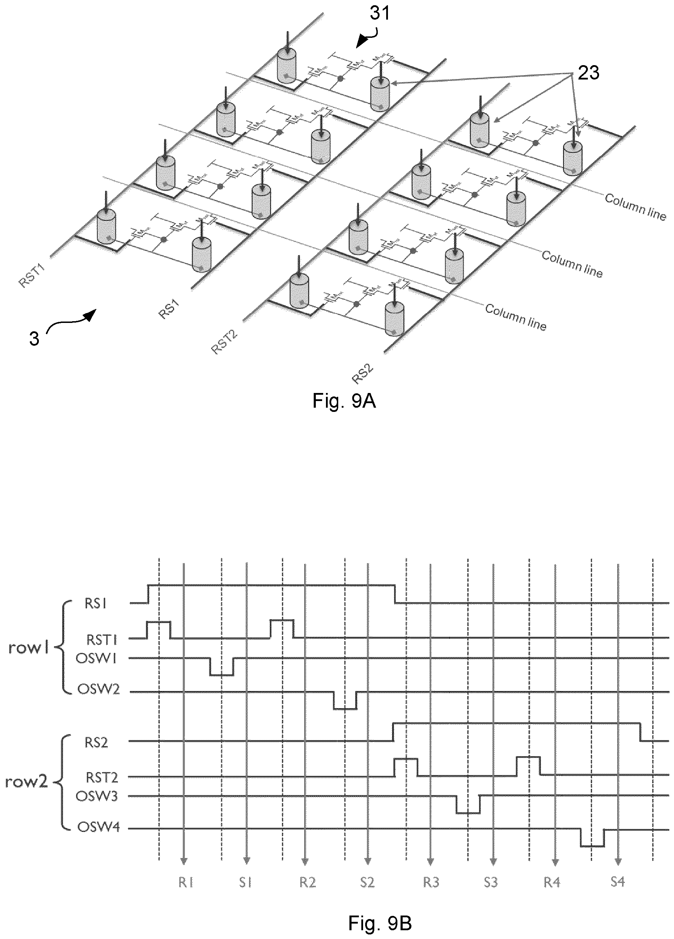

In connection with Fig. 9A, shared readout circuits and shared floating diffusion regions will be discussed in detail.

At least two strings of the plurality of strings of charge storage capacitors (channels) may be connected to one of the plurality of readout circuits 31 for reading out the signal representative of the charge stored in said at least two strings of the plurality of strings of charge storage capacitors (channels).

At least two strings of the plurality of strings of charge storage capacitors (channels) may be connected to one floating diffusion region 27 for connecting to one of the plurality of readout circuits 31.

In Fig. 9A, two channels (two strings of charge storage capacitors) are connected to one readout circuit 31 via one floating diffusion region (not shown). In other words, these two strings of charge storage capacitors (channels) share the same floating diffusion region and the same readout circuits 31 for reading out.

Extending to the array of the readout circuits 31, two rows of strings of charge storage capacitors (channels) share the same row of floating diffusion region and the same row of readout circuits 31 for reading out.

There may be a different number, e.g., four, eight, sixteen, etc., of strings of charge storage capacitors (channels) connecting to one readout circuit 31 via one floating diffusion region.

This is advantageous as the pixel pitch can be further reduced as fewer components are needed.

In connection with Fig. 9B, the CDS operation timing diagram of the 3D integrated CCD based imager as shown in Fig. 9A will be discussed in detail.

In Fig. 9A, two rows of strings of charge storage capacitors (channels) share one row of readout circuit 31 for reading out. Thus, each pair of the row select signal RSn and the reset signal RSTn can be used for reading out two rows of strings of charge storage capacitors (channels) that share the same readout circuit 31.

In contrast, each pair of the row select signal RSn and the reset signal RSTn in the example of Fig. 8 can only be used for reading out a single row of strings of charge storage capacitors (channels).

In this example, the charge of the two rows of strings of charge storage capacitors that share the first row of the readout circuits can be individually read out by OSW1 and OSW2. The charge of the two rows of strings of charge storage capacitors that share the second row of the readout circuits can be individually read out by OSW3 and OSW4.

The CDS operation may comprise the following steps, similar to the example of Fig. 8.
1) The row select signal RS1 is set to be "High" to enable row 1 of the readout circuits.

The reset signal RST1 is a "High" pulse to reset the floating diffusion region(s) connected to row 1 of the readout circuits.

The row select signal RS2 and the row reset signal RST2 are inactive, i.e. "Low".

OSW1, OSW2, OSW3 and OSW4 are inactive, i.e. "High".

2) A first signal R1 of row 1 is read out, after the floating diffusion region(s) has been reset.

The first signal R1 may comprise a group of signals read out by multiple readout circuits of row 1 of the readout circuits. In other words, multiple readouts may have been done simultaneously by multiple readout circuits of row 1. For example, if there are four readout circuits of row 1, the first signal R1 may comprise readouts from all four readout circuits.

The first signal R1 may represent a combination of a reset voltage and a noise value.

All control signals remain unchanged.

3) OSW1 is set to be a "Low" pulse to sum charge of each string of charge storage capacitors connected to the separated OSW layer portion receiving the signal OSW1 for outputting.

All other control signals remain unchanged.

4) A second signal S1 of row 1 is read out.

The second signal S1 may comprise a group of signals read out by multiple readout circuits of row 1 of the readout circuits. In other words, multiple readouts may have been done simultaneously by multiple readout circuits of row 1. For example, if there are four readout circuits of row 1 each connected to a string of charge storage capacitors, the second signal S1 may comprise readouts from all four strings of charge storage capacitors.

The second signal S1 of row 1 may be representative of the charge stored in the strings of charge storage capacitors connected to the separated OSW layer portion receiving the signal OSW1.

That is, the signals of one row of the two rows of strings of charge storage capacitors (channels) sharing row 1 of the readout circuits can be read out.

Subtracting the first signal R1 from the second signal S1 respectively may reduce noise.

5) The reset signal RST1 is a "High" pulse to reset the floating diffusion region(s) connected to row 1 of the readout circuits.

All other control signals remain unchanged.

6) A first signal R2 of row 1 is read out, after the floating diffusion region(s) has been reset.

The first signal R2 may comprise a group of signals read out by multiple readout circuits of row 1 of the readout circuits. In other words, multiple readouts may have been done simultaneously by multiple readout circuits of row 1. For example, if there are four readout circuits of row 1, the first signal R2 may comprise readouts from all four readout circuits.

7) OSW2 is set to be a "Low" pulse to sum charge of each string of charge storage capacitors connected to the separated OSW layer portion receiving the signal OSW2 for outputting.

All other control signals remain unchanged.

8) A second signal S2 of row 1 is read out.

The second signal S2 may comprise a group of signals read out by multiple readout circuits of row 1 of the readout circuits. In other words, multiple readouts may have been done simultaneously by multiple readout circuits of row 1. For example, if there are four readout circuits of row 1 each connected to a string of charge storage capacitors, the second signal S2 may comprise readouts from all four strings of charge storage capacitors.

The second signal S2 of row 1 may be representative of the charge stored in the strings of charge storage capacitors connected to the separated OSW layer portion receiving the signal OSW2.

That is, the signals of another row of the two rows of strings of charge storage capacitors (channels) sharing row 1 of the readout circuits can be read out.

Subtracting the first signal R2 from the second signal S2 respectively may reduce noise.

The CDS operation may be performed in a row-by-row manner similar to the above steps for each row of the readout circuits.

For example, the above can be repeated for a second row of the readout circuits with the row select signal RS2, the reset signal RST2, the separated OSW layer portion control signals OSW3 and OSW4.

This is advantageous as the pixel pitch can be further reduced as fewer components are needed. However, the time for reading out is increased.

There may be a different number, e.g., four, eight, sixteen, etc., of strings of charge storage capacitors connecting to one readout circuit 31 via one floating diffusion region.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A three-dimensional, 3D, integrated Charge-Coupled Device, CCD, based imager (10), comprising:
- a photosensitive layer (1), comprising:
a plurality of pixels arranged in a two-dimensional, 2D, matrix, each pixel configured to perform photoelectric conversion by generating a charge in response to incident light, and to transfer the charge to a CCD gate stack (2) for storage;
- the CCD gate stack (2), configured to store and transfer charge; and
- a readout layer (3), configured to read out a signal representative of the charge stored in the CCD gate stack (2);
wherein the CCD gate stack (2) comprises:
a plurality of gate layers (21) and a plurality of spacer layers (22), which are alternatingly arranged one on the other along a first direction (Y);
a plurality of channels (23) extending in the CCD gate stack along the first direction (Y); and
a plurality of dielectric layers (24) extending in the CCD gate stack along the first direction (Y), configured to isolate the plurality of channels (23) from the plurality of gate layers (21);
wherein each of the plurality of channels (23) forms, in combination with the plurality of gate layers (21) and at least one of the dielectric layers (24), a string of charge storage capacitors (25);
wherein each of the plurality of pixels is configured to connect to one of a plurality of strings of charge storage capacitors (25), for transferring the generated charge;
wherein each string of the plurality of strings of charge storage capacitors (25) is configured to operate as a charge shift register;
wherein at least a part of the CCD gate stack (2) is sandwiched between the photosensitive layer (1) and the readout layer (3) along the first direction (Y); and
wherein the plurality of gate layers (21) comprises at least three gate layers (21) along the first direction, including a first gate layer (211), a second gate layer (212), ..., and a last gate layer (21n), wherein the first gate layer (211) is the gate layer closest to the photosensitive layer (1) and the last gate layer (21n) is the gate layer closest to the readout layer (3).

2. The 3D integrated CCD based imager according to claim 1, wherein the photosensitive layer (1) comprises:
a photoelectric conversion layer (11), configured to generate charge in response to the incident light, and
a charge transport layer (12), configured to collect and transfer the generated charge to the CCD gate stack (2) for storage,
preferably, the first gate layer (211) is a photogate layer configured to control a potential of the charge transport layer (12);
and/or
wherein the photosensitive layer (1) is made of Si or Ge photodiodes, preferably a Pinned Photodiodes, PPDs, with deep trench isolation in a silicon substrate, and
wherein the photosensitive layer (1) is integrated with the CCD gate stack (2) by wafer stacking.

3. The 3D integrated CCD based imager according to claim 1 or 2, wherein the second gate layer (212) is an input transfer gate, ITG, layer, configured to control charge transfer from the photosensitive layer (1) to the plurality of strings of charge storage capacitors;
and/or
wherein the last gate layer (21n) is an output transfer gate, OTG, layer configured to transfer the charge stored in the CCD gate stack (2) to the readout layer (3).

4. The 3D integrated CCD based imager according to any of claims 1 to 3, wherein the second last gate layer (21(n-1)), which is arranged between the last gate layer (21n) and the other layers of the plurality of gate layers (211, 212, ... , 21(n-2)), is a buffer gate layer or an Output Summing Well, OSW, layer.

5. The 3D integrated CCD based imager according to claim 4, when the second last gate layer (21(n-1)) is the OSW layer,
wherein the OSW layer comprises at least a first and a second separated OSW layer portion,
wherein a first group of channels of the plurality of channels (23) extend through the first separated OSW layer portion along the first direction (Y), and a second group of channels of the plurality of channels (23) extend through a second separated OSW layer portion along the first direction (Y);
preferably, the first group of channels are a first row of channels of the plurality of channels (23), and the second group of channels are a second row of channels of the plurality of channels (23).

6. The 3D integrated CCD based imager according to any of claims 1 to 5,
wherein at least two charge storage capacitors (25) of at least one string of the plurality of strings of charge storage capacitors are provided with a respective clock signal having a different phase; and/or
wherein at least two neighboured charge storage capacitors (25) of the charge storage capacitors along the first direction (Y) of at least one string of the plurality of strings of charge storage capacitors are provided with a clock signal having the same phase.

7. The 3D integrated CCD based imager according to any of claims 1 to 6, wherein the readout layer (3) comprises a plurality of readout circuits (31), configured to read out the signal representative of the charge stored in the plurality of strings of charge storage capacitors;
wherein at least one string of the plurality of strings of charge storage capacitors is connected to one of the plurality of readout circuits (31) via a floating diffusion region (27);
preferably, at least a last charge storage capacitor of at least one string of the plurality of strings of charge storage capacitors is configured to function as a storage Metal Oxide Semiconductor, MOS, capacitor of the floating diffusion region (27) connected to said string of the plurality of strings of charge storage capacitors,
wherein the last charge storage capacitor is positioned at a distal end of said string of the plurality of strings of charge storage capacitors, wherein the distal end is in electrical charge transfer proximity to the readout layer (3).

8. The 3D integrated CCD based imager according to claim 7,
wherein at least two strings of the plurality of strings of charge storage capacitors are connected to one of the plurality of readout circuits (31) for reading out the signal representative of the charge stored in said at least two strings of the plurality of strings of charge storage capacitors;
and/or
wherein at least two strings of the plurality of strings of charge storage capacitors are connected to the floating diffusion region (27) for connecting to one of the plurality of readout circuits (31).

9. The 3D integrated CCD based imager according to any of claims 1 to 8,
wherein the plurality of channels (23) are made of a channel material comprising any of: indium gallium zinc oxide, IGZO, indium tin oxide, ITO, indium zinc oxide, IZO, another wide-bandgap semiconductor oxide material, a silicon-based semiconductor material and a III-V semiconductor material;
and/or
wherein at least one channel of the plurality of channels (23) is made of a channel material having a varying dielectric constant along the first direction (Y).

10. The 3D integrated CCD based imager according to any of claims 2 to 9, wherein at least one of the plurality of channels (23) and the charge transport layer (12) are made of a same material.

11. The 3D integrated CCD based imager according to any of claims 1 to 10, wherein the plurality of gate layers (21) are made of a gate layer material comprising any of a metal material or doped semiconductor material,
wherein the metal material comprises any of: platinum, Pt, tantalum, Ta, tantalum nitride, TaN, metal silicide, aluminium, Al, Titanium, Ti, Titanium nitride, TiN, Ruthenium, Ru, Iridium, Ir, Iridium dioxide, IrOz, Ruthenium oxide, RuO₂, Tungsten, W, and Tungsten nitride, WN,
wherein the doped semiconductor material comprises P+ polysilicon or N+ polysilicon;
and/or
wherein at least two gate layers of the plurality of gate layers (21) are made of different gate materials.

12. The 3D integrated CCD based imager according to any of claims 1 to 11, wherein the plurality of gate layers (21) is arranged in a staircase configuration, such that each successive layer of the plurality of gate layers (21) has a length in a second direction (X) being larger than a length in the second direction of its preceding layer of the plurality of gate layers (21);
wherein the second direction (X) is perpendicular to the first direction (Y);
wherein each of the plurality of gate layers (21) is provided with a contact via (26) for receiving a control signal;
and wherein, preferably, at least one layer of the plurality of gate layers (21) comprises multiple sub-steps arranged in a staircase configuration, such that each successive sub-step of said at least one layer has a length in a third direction being larger than a length in the third direction of its preceding sub-step of said at least one layer,
wherein the third direction is perpendicular to both the first and second direction.

13. An imaging method performed by using the 3D integrated CCD based imager (10) according to any of claims 1- 12, comprising:
exposing the photosensitive layer (1) to incident light representative of an image during a frame time (T_{frame});
the plurality of pixels of the photosensitive layer (1) performing photoelectric conversion by generating charge in response to the incident light, and transferring the charge to the CCD gate stack (2) for storage;
the CCD gate stack (2) storing and transferring charge; and
the readout layer (3) reading out a signal representative of the charge stored in the CCD gate stack (2) for reconstructing an image frame representative of the image;
wherein the step of the CCD gate stack (2) storing and transferring charge comprises:
each string of the plurality of strings of charge storage capacitors (25)
storing the generated charge transferred from one of the plurality of pixels connected to said string of charge storage capacitors (25), and
operating as a charge shift register by transferring the charge along the first direction (Y) towards the readout layer (3) for reading out.

14. The imaging method according to claim 13,
wherein the step of exposing the photosensitive layer (1) to incident light representative of an image during a frame time (T_{frame}), comprises:
sequentially exposing the photosensitive layer (1) to the incident light with a same or different exposure times a first number of times within the frame time (T_{frame});
wherein the step of the readout layer (3) reading out a signal representative of the charge stored in the CCD gate stack (2) for reconstructing an image frame representative of the image, comprises:
the readout layer (3) sequentially reading out a first number of signal portions of the signal for respectively reconstructing a first number of image subframes, each image subframe at least being partially representative of the image;
preferably, the first number of image subframes have a same subframe time (T_{subframe}) being equal to the frame time (T_{frame}) divided by the first number.

15. The imaging method according to claim 13 or 14,
when the second last gate layer (21(n-1)) is the OSW layer,
wherein the OSW layer comprises at least a first and a second separated OSW layer portion,
wherein a first group of channels of the plurality of channels (23) extend through the first separated OSW layer portion along the first direction (Y), and form a first group of strings of charge storage capacitors (25, and
a second group of channels of the plurality of channels (23) extend through the second separated OSW layer portion along the first direction (Y), and form a second group of strings of charge storage capacitors (25;
wherein the readout layer (3) comprises a plurality of readout circuits (31) for reading out the signal representative of the charge stored in the plurality of strings of charge storage capacitors;
wherein the first group of strings of charge storage capacitors (25) are connected to a first group of readout circuits of the plurality of readout circuits (31) via a first group of floating diffusion regions (27), respectively, and the second group of strings of charge storage capacitors (25) are connected to a second group of readout circuits of the plurality of readout circuits (31) via a second group of floating diffusion regions (27), respectively;
wherein the step of the readout layer (3) reading out a signal representative of the charge stored in the CCD gate stack (2) for reconstructing an image frame of the image, comprises:
resetting the first group of floating diffusion regions (27),
the first group of readout circuits simultaneously reading out a first group of reset signals of the first group of floating diffusion region (27, respectively,
controlling the first separated OSW layer portion for transferring the charge stored in the first group of strings of charge storage capacitors (25) to the first group of floating diffusion regions (27) for reading out,
the first group of readout circuits simultaneously reading out a second group of signals representative of the charge stored in the first group of strings of charge storage capacitors (25), respectively, and
subtracting the first group of reset signals of the first group of floating diffusion region (27) from the second group of signals representative of the charge stored in the first group of strings of charge storage capacitors (25), respectively, for noise cancellation;
and
resetting the second group of floating diffusion regions (27),
the second group of readout circuits simultaneously reading out a first group of reset signals of the second group of floating diffusion regions (27, respectively,
controlling the second separated OSW layer portion for transferring the charge stored in the second group of strings of charge storage capacitors (25) to the second group of floating diffusion regions (27) for reading out,
the second group of readout circuits simultaneously reading out a second group of signals representative of the charge stored in the second group of strings of charge storage capacitors (25), respectively, and
subtracting the first group of reset signals of the second group of floating diffusion regions (27) from the second group of signals representative of the charge stored in the second group of strings of charge storage capacitors (25), respectively, for noise cancellation;
preferably, the first group of channels are a first row of channels of the plurality of channels (23), and the second group of channels are a second row of channels of the plurality of channels (23).
